# EUROPEAN PATENT SPECIFICATION

(11) **EP 0 780 986 B1**
(45) Date of publication and mention of the grant of the patent: **16.02.2005**
(21) Application number: 96402783.3
(22) Date of filing: 18.12.1996
(51) Int. Cl.: H03M 1/10

(54) **Auto calibrated digital to analog converter for a video display**
Selbstkalibrierender Digital-Analog-Wandler für ein Video-Sichtgerät
Convertisseur numérique-analogique à autocalibration pour un dispositif d'affichage vidéo

(30) Priority: 22.12.1995 US 577172
(43) Date of publication of application: 25.06.1997
(60) Divisional application: 04007223.3
(73) Proprietor: Thomson, 92648 Boulogne Cedex (FR)
(72) Inventor: Dingwall, Andrew Gordan Francis, 92050 Paris la Defense Cedex (FR)
(74) Representative: Ruellan-Lemonnier, Brigitte

(56) References cited:
- EP-A- 0 061 199
- EP-A- 0 281 116
- US-A- 4 914 440
- US-A- 5 703 582

## Description

This invention relates generally to digital-to-analog converters used for applying brightness signals to pixels of a display device and particularly in a liquid crystal display (LCD).

Display devices, such as LCD's, are composed of a matrix or an array of pixels arranged horizontally in rows and vertically in columns. The video information to be displayed is applied as brightness (gray scale) signals to data lines which are individually associated with each column of pixels. The row of pixels are sequentially scanned and the capacitances of the pixels within the activated row are charged to the various brightness levels in accordance with the levels of the brightness signals applied to the individual columns.

U.S. Patent No. 5,170,155 in the names of Plus et al., (Plus et al.,) entitled "System for Applying Brightness Signals To A Display Device And Comparator Therefore", describes an example of data line or column drivers of an LCD array. In the Plus et al., arrangement, the video information is stored in a digital format in a memory having output lines. Each group of output lines applies the stored digital information to a corresponding digital-to-analog (D/A) converter. An output signal of a given D/A converter is coupled to a corresponding data line driver that drives a corresponding data line of the LCD array.

United States No. 4,827,260 entitled "DIGITAL-TO ANALOG CONVERTER" in the names of Sugawa et al., describes a D/A converter for video signal processing referred to as a current-segment or current-summation type D/A converter. In an example of such D/A converter for an n-bit data word, 2ⁿ-1 identical current sources are controlled by 2ⁿ-1 switches. The switches are selectively turned on in accordance with the states of the bits of the data word. The currents of the current sources associated with the conductive switches are combined in a current summing resistor to produce a sum current. The value of the sum current increases by the value of the current of one current source when the value of the data word increases by one. An analog output voltage that is proportional to the sum current is developed in the resistor.

A relatively large number of, for example, current-summation type D/A converters, for example, 40, may be used for simultaneously apply the video information to the corresponding 40 data line drivers. Advantageously, such parallel operation of the D/A converters provides a shorter cycle time for updating the pixel information associated with a given row.

European patent application 0 061 199 entitled "Digital to analog converter" in the name of Hitachi Ltd describes a D/A converter comprising a switched network which generates an analog output signal in response to a corresponding input data word.

A D/A converter for LCD display may require an accuracy of, for example, greater than 0.25%. However, the output voltages of the D/A converters for a given data word may be required to match with an even higher accuracy. Such matching accuracy may be required in order to avoid an objectionable perception of color tone or grey scale variations in a portion of a displayed image that is supposed to be uniform.

Typically, a single D/A converter of a current summation type may be constructed using a common centroid layout technique to prevent significant deviations of process parameters among the current sources D/A converter. However, because of the large number of D/A converters required in the drive circuitry of an LCD, it is not practical to obtain the aforementioned common centroid layout with respect to all of the current sources of such D/A converters. Furthermore, the summing resistors of the different D/A converters may suffer from mismatch because each may be subject to an inaccuracy greater than, for example, 1%. It may be desirable to calibrate the D/A converters automatically and periodically during the operation of the LCD display for improving the accuracy of the D/A converters.

In a given D/A converter, embodying an inventive feature, the current sources are controlled in common in a current mirror arrangement by a control signal.

In accordance with an aspect of the invention, a current summation type digital-to-analog converter includes a plurality of switched current sources that are controlled in common in a current mirror arrangement and that are selected in accordance with an input data word. An analog output signal is produced from the currents of the selected current sources. A comparator is responsive to a reference signal and to a signal that is indicative of the output signal for generating an error signal in accordance with a difference therebetween. The error signal is coupled to the current mirror arrangement for automatically adjusting the analog output signal in a servo-loop manner.
FIGURE 1 illustrates a liquid crystal display arrangement that includes self-calibrated D/A converters, embodying an aspect of the invention; and
FIGURE 2 illustrates in detail one of the self-calibrated D/A converters of FIGURE 1.

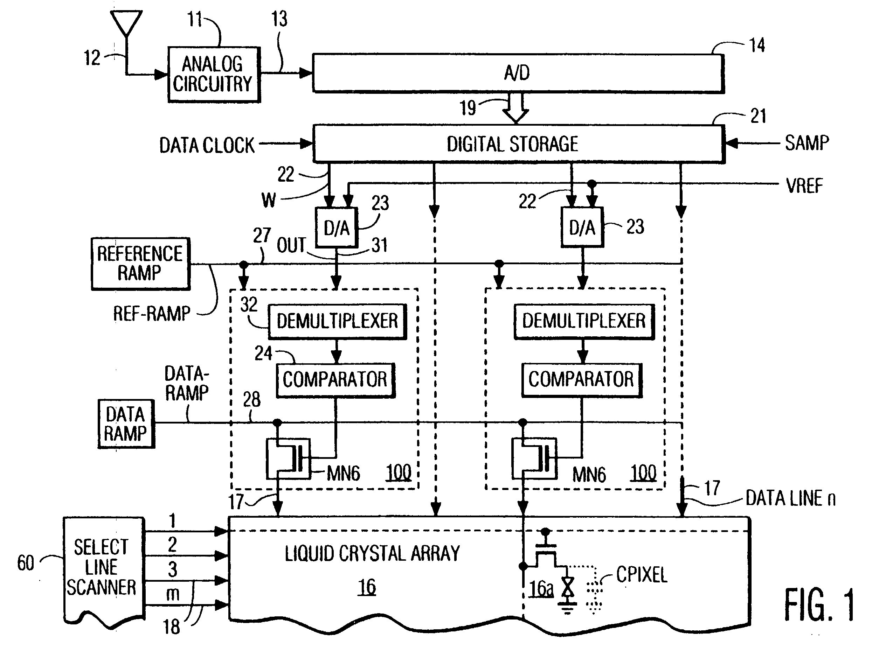

In FIGURE 1, a video signal representative of picture information to be displayed is received from, for example, an antenna 12. An analog circuitry 11 provides a video signal on a line 13 as an input signal to an analog-to-digital converter (A/D) 14. The television signal from the analog circuitry 11 is displayed on a liquid crystal array 16 which is composed of a large number of pixel elements, such as a liquid crystal cell 16a, arranged horizontally in m = 560 rows and vertically in n = 960 columns. Liquid crystal array 16 includes n = 960 columns of data lines 17, one for each of the vertical columns of liquid crystal cells 16a, and m = 560 select lines 18, one for each of the horizontal rows of liquid crystal cells 16a.

A/D converter 14 includes an output bus bar 19 to provide brightness levels, or gray scale codes, to a memory 21 having 40 groups of output lines 22. Each group of output lines 22 of memory 21 applies the stored digital information to a corresponding digital-to-analog (D/A) converter 23, embodying an inventive feature. There are 40 D/A converters 23 that correspond to the 40 groups of lines 22, respectively. An output signal OUT of a given D/A converter 23 is coupled via a corresponding line 31 to a corresponding demultiplexer and data line driver 100 that stores signal OUT.

During a 13 microsecond interval of a given video line time, signals OUT of the 40 D/A converters 23 are produced and stored in each of 24 successive conversion cycles. As a result, signals OUT are stored in each of the 960 demultiplexer and data line drivers 100. The time between conversion cycles is approximately 1.24 microsecond.

A select line scanner 60 produces row select signals in lines 18 for selecting, in a conventional manner, a given row of array 16. The voltages developed in 960 data lines 17 are applied, during a 32 microsecond line time, to pixels 16a of the selected row.

As indicated before, a given demultiplexer and data line driver 100 is used to store corresponding signal OUT and to transfer stored signal OUT to corresponding data line 17. Each data line 17 is applied to 560 rows of pixel cells 16a. ) Demultiplexer and data line driver 100 operates as a chopped ramp amplifier. A reference ramp signal REF-RAMP and signal OUT are applied to a comparator 24 that controls an output transistor MN6. A data ramp voltage DATA-RAMP is applied to data line 17 by transistor MN6, during each video line time, until an instant when comparator 24 disables transistor MN6. The instant when comparator 24 disables transistor MN6, is determined by the magnitude of signal OUT. Thus, the pixel voltage is determined by signal OUT. An example of an arrangement that may be similar to the demultiplexer and data line driver 100 is explained in detail in the Plus et al., patent.

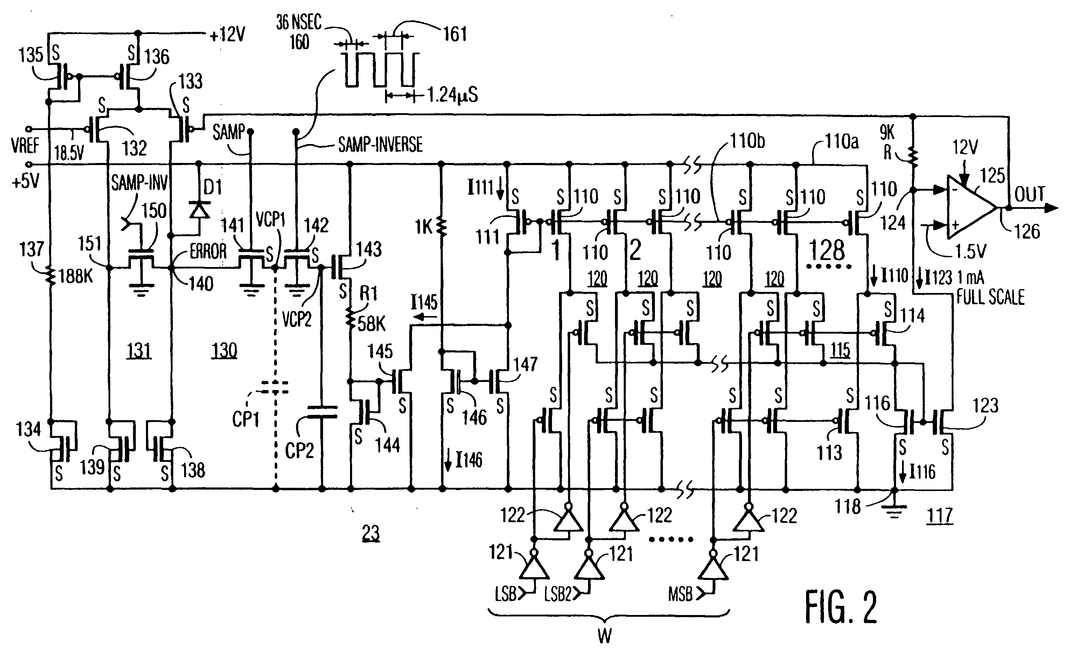

FIGURE 2 illustrates in details one of the self-calibrated D/A converters 23 of FIGURE 1, embodying an inventive feature. Similar symbols and numerals in FIGURES 1 and 2 indicate similar items or functions.

Each of self-calibrated D/A converters 23 of FIGURE 2 converts an 8-bit data word W containing pixel video information to analog voltage OUT. It includes, for example, 2⁸-1=255 switched current sources 120 that are constructed to match one another by using, for example, a common centroid layout. Each switched current source 120 includes a non-switched current source transistor 110, formed by a P-type metal oxide semiconductor (PMOS) transistor. Each transistor 110 has a source electrode that is coupled via a common line 110a to a supply voltage +5V and a gate electrode that is coupled in common with the gate electrodes of the other transistors 110 via a line 110b. Line 110b is coupled to a drain electrode of a current control PMOS transistor 111. Transistor 111 has its gate and drain electrodes coupled to each other. A control current I111 in transistor 111 controls a magnitude of a current I110 in each transistor 110 in a current mirror manner. Each current I110 has the same magnitude and tracks each current I110 of the other transistors 110 of D/A converter 23.

In a given switched current source 120, current source transistor 110 is coupled to a source electrode of a corresponding PMOS switch transistor 113 and to a source electrode of a corresponding PMOS switch transistor 114. The drain electrodes of transistors 114 are coupled in common to a drain electrode of a current summing N-type metal oxide semiconductor (NMOS) transistor 116 of a current mirror arrangement 117. The drain electrodes of each of transistors 113 are coupled to a ground reference terminal 118.

Switched current sources 120 are organized in 8 groups that are controlled by the 8 bits of word W, respectively. The number of switched current sources 120 that are included in a given group is determined by the weight of the corresponding bit of word W that controls the switched current sources 120 in the group. Thus, for example, 127 switched current sources 120 are controlled by a most significant bit MSB of word W; whereas, one switched current source 120 is controlled by a least significant bit LSB of word W. There are total 255 switched current sources 120 in D/A converter 23.

The gate electrodes of each of transistors 114 of a given group of switched current sources 120 are coupled in common to an output of a corresponding inverter gate 121. Inverter gate 121 applies a logic level LOW when the corresponding bit of word W is at a logic level HIGH in a manner to turn on transistors 114. Consequently, current I110 in each transistor 110 is coupled via the corresponding transistor 114 to current summing transistor 116 and contributes to a current I116 in transistor 116. Thus, a current I116 in transistor 116 is increased by an amount that is determined by the weight of the controlling bit of word W.

The gate electrodes of each of transistors 113 of such group of switched current sources 120 are coupled in common to an output of a corresponding inverter gate 122. Inverter gate 122 applies a logic level HIGH when the corresponding bit of word W is at the logic level HIGH. Consequently, transistors 113 are turned off.

On the other hand, the corresponding inverter gate 121 applies a logic level HIGH when the corresponding bit of word W is at a logic level LOW. Consequently, transistors 114 are turned off and transistors 113 are turned on in a manner to decouple current I110 in each transistor 110 from current summing transistor 116. Thus, currents 110 do not contribute to current I116 in transistor 116 when the bit of word W is at logic level LOW.

Advantageously, current I110 continues to flow undisturbed in one of transistors 113 and 114 regardless of the state of the controlling bit of word W. In this way any current switching disturbance is, advantageously, reduced.

Full scale of voltage OUT occurs when each current I110 in D/A converter 23 is coupled to transistor 116. This situation occurs when all the 8 bits of word W are at the HIGH state. Zero scale occurs when none of currents I110 is coupled to transistor 116. This situation occurs when the 8 bits of word W are in the LOW state.

Sum current I116 controls a sum current I123 in a transistor 123 in a current mirror manner. It follows that sum current I123 increases by a value proportional to current I110 when the value of data word W increases by one.

Current I123 is coupled to an inverting terminal 124 of an inverting amplifier 125. An output terminal 126 of inverting amplifier 125 is coupled to terminal 124 via a resistor R. A level shifting voltage of 1.5V is coupled to a non-inverting input terminal of amplifier 125. Consequently, analog output voltage OUT of amplifier 125 is equal to 1.5V+(the value of sum current I123 multiplied by the value of resistor R). When the value of each bit of word W is zero, voltage OUT is equal to 1.5V. Thus, voltage 1.5V determines the zero scale level of voltage OUT.

A self-calibrating circuit 130, embodying an inventive feature, includes a differential, error amplifier 131 having an inverting input terminal that is coupled to output terminal 126 of amplifier 125 and a non-inverting input terminal that is coupled to a source, not shown, of a reference voltage VREF corresponding to the VREF shown in FIGURE 1. Amplifier 131 includes a differential pair of PMOS transistors 132 and 133 coupled to a pair of NMOS load transistors 138 and 139, respectively. A PMOS transistor 135, a current control resistor 137 and a transistor 134 that are coupled in series control the sum of the currents in transistors 132 and 133 via a transistor 136 in a current mirror manner.

An output terminal 140 of error amplifier 131 is coupled via an error sampling switching NMOS transistor 141 to a small sampling capacitance CP1 that may be a parasitic capacitance. Capacitance CP1 is coupled via a switching NMOS transistor 142 to a second, integrating capacitance CP2. Transistors 141 and 142 are controlled by complementary control signals SAMP and SAMP-INVERSE, respectively. A clamp transistor 150 is coupled between terminal 140 and a junction terminal 151. Junction terminal 151 is coupled between transistors 132 and 139.

Periodic error sampling of D/A converter 23 occurs during an error sampling interval 160 of signal SAMP-INVERSE, between successive digital-to-analog conversion intervals 161. During error sampling interval 160, a pulse of sampling control signal SAMP turns on transistor 141 and complementary pulse of sampling control signal SAMP-INVERSE turns off transistor 142. During sampling interval 160, signal SAMP is applied to an output stage, not shown, of memory 21 of FIGURE 1 for producing word W having all its bits at the logic HIGH state. Signal SAMP-INVERSE turns off transistor 150 in a manner to enable the generation of an error signal ERROR at terminal 140. Consequently, capacitance CP1 develops an error correction voltage VCP1 that is proportional to a difference between voltage OUT, at full scale, and voltage VREF.

After sampling interval 160, sampling control signal SAMP turns off transistor 141 and sampling control signal SAMP-INVERSE turns on transistor 142. Consequently, a charge stored in capacitance CP1 that is indicative of an error in voltage OUT at full scale is applied to error integrating capacitor CP2 for generating a control voltage VCP2. In steady state operation, voltage VCP2 tends to maintain closely voltage OUT at the level of voltage VREF.

Clamp transistor 150 is conductive at all times except during interval 160. Therefore, advantageously, outside sampling interval 160, a signal developed at terminal 140 is constant in a manner to prevent the introduction of a noise signal to capacitances CP1 and CP2.

Voltage VCP2 is coupled via a source follower NMOS transistor 143 to a voltage-to-current converter formed by a series arrangement of a resistor R1 and an NMOS transistor 144. Transistor 144 has its gate electrode coupled to its drain electrode. The drain/gate of transistor 144 are coupled to the gate of an NMOS transistor 145 to form a current mirror arrangement. A current I145 in transistor 145 is proportional to control voltage VCP2. Current I145 is a variable current that is summed with a constant current I147 in a transistor 147 to flow as a sum current I111 in transistor 111. Current I147 is established in a current mirror way by a current I146 flowing in a transistor 146. Current I111 controls each of currents I110 in a current mirror manner.

A difference or an error between voltages OUT and VREF causes current I145, hence, current I111 to change. Consequently, a change occurs in each of currents I110. Thus, the error in current I110 is corrected in a servo-loop manner. The error may be corrected at least partially during a given sampling interval 160. A large error may require several sampling intervals for complete correction.

In accordance with an inventive feature, the error in each of D/A converters 23 is corrected using the same reference voltage VREF. Therefore, advantageously, differences in the values of resistors R or in the values of currents I110 among D/A converters 23 do not significantly affect the matchings of voltages OUT at full scale. Voltage OUT at zero scale is not significantly affected by resistors R or by currents I110 because currents I110 are zero at zero scale. At any intermediate value of word W the accuracy is maintained because, in each D/A converter 23, currents I110 are equal to one another. Each transistor of D/A converter 23 may be implemented using bipolar transistor technology.

## Claims

1. A current summation type digital-to-analog converter, comprising:
a source of an input data word (W), **characterized by** :
a plurality of switched current sources (120) that are controlled in common in a current mirror arrangement (110,111) and that are selected in accordance with said data word to produce from the currents of the selected current sources an analog output signal (voltage at 124);
a source of a reference signal (VREF) at a reference level; and
a comparator (131) responsive to said reference signal and to a signal that is indicative of said output signal for generating an error signal (ERROR) in accordance with a difference therebetween, said error signal being coupled to said current mirror arrangement for automatically adjusting said analog output signal in a servo-loop manner.

2. A digital-to-analog converter according to Claim 1 further **characterized by**, a first switch (141) responsive to a periodic switch control signal (SAMP) and coupled to a first capacitance (VCP1) and to said comparator for sampling said error signal, during an error sampling interval, and for storing said sampled error signal in said first capacitance to produce a conversion scale control signal (1145) that is coupled to said current mirror arrangement of said digital-to-analog converter to control a conversion scale.

3. A digital-to-analog converter according to Claim 2 further **characterized by**, a second capacitance (CP2) that is coupled to said first capacitance (CP1 ), outside said error sampling interval, to integrate said sampled error signal in said second capacitance.

4. A digital-to-analog converter according to Claim 2 **characterized in that**, during said error sampling interval, said data word (W) has a predetermined value (11.....1) that is associated with said level of said reference signal and, 5 outside said error sampling interval, said data word contains pixel video information.

5. A digital-to-analog converter according to Claim 4 **characterized in that**, during said error sampling interval (ERROR), a value of said input data word (11.....1) that is applied to said digital-to-analog converter corresponds to a full 0 scale output signal.

6. A plurality of digital-to-analog converters according to Claim 1 wherein said switched network comprises a plurality of switched current sources of a current summation type digital-to-analog converter and wherein each of said plurality of switched current sources is adjusted by said error signal in a current mirror arrangement.

7. A plurality of digital-to-analog converters according to Claim 6 wherein said switched current sources comprise a plurality of non-switched current sources controlled in common by said error signal and a plurality of switches coupled to said non-switched current sources to form said switched current sources.

## Patentansprüche

1. Digital/Analog-Converter vom Typ mit Stromsummierung mit:
einer Quelle eines Eingangsdatenwortes (W), **gekennzeichnet durch**:
mehrere geschaltete Stromquellen (120), die gemeinsam in einer Stromspiegelanordnung (110, 111) gesteuert und entsprechend dem Datenwort ausgewählt werden zur Erzeugung eines analogen Ausgangssignals aus den Strömen der gewählten Stromquellen (Spannung bei 124),
einer Quelle eines Referenzsignals (VREF) bei einem Referenzwert und
einem auf das Referenzsignal und ein Signal ansprechenden Komparator (131), der das Ausgangssignal für die Erzeugung eines Fehlersignals (ERROR) entsprechend einer Differenz dazwischen anzeigt, wobei das Fehlersignal der Stromspiegelanordnung zur automatischen Einstellung des analogen Ausgangssignals in der Art einer Servoschleife zugeführt wird.

2. Digital/Analog-Converter nach Anspruch 1, **gekennzeichnet durch** einen ersten Schalter (141), der **durch** ein periodisches Schaltsteuersignal (SAMP) gesteuert wird und mit einer ersten Kapazität (VCP1) und mit dem Komparator zur Abtastung des Fehlersignals verbunden ist während eines Fehlerabtastintervalls, und zur Speicherung des abgetasteten Fehlersignals in der ersten Kapazität zur Erzeugung eines Steuersignals (1145) für die Umsetzaussteuerung, das der Stromspiegelanordnung des Digital/Analog-Converters zur Steuerung einer Umsetzskala zugeführt wird.

3. Digital/Analog-Converter nach Anspruch 2, **gekennzeichnet durch** eine zweite Kapazität (CP2), die mit der ersten Kapazität (CP1) verbunden ist, außerhalb des Fehlerabtastintervalls zur Integrierung des abgetasteten Fehlersignals in der zweiten Kapazität.

4. Digital/Analog-Converter nach Anspruch 2, **dadurch gekennzeichnet, dass** während des Fehlerabtastintervalls das Datenwort (W) einen vorbestimmten Wert (11.....1 ) hat für den ersten Wert des Referenzsignals und außerhalb des Fehlerabtastintervalls das Datenwort Pixel-Videoinformationen enthält.

5. Digital/Analog-Converter nach Anspruch 4, **dadurch gekennzeichnet, dass** während des Fehlerabtastintervalls (ERROR) ein Wert des Eingangsdatenwortes (11.....1), der dem Digital/Analog-Converter zugeführt wird, einer vollen Aussteuerung des Ausgangssignals entspricht.

6. Mehrere Digital/Analog-Converter nach Anspruch 1, wobei das geschaltete Netzwerk mehrere geschaltete Stromquellen eines Digital/Analog-Converters vom Typ mit Stromsummierung enthält und wobei jeder der mehreren geschalteten Stromquellen durch das Fehlersignal in einer Stromspiegelanordnung eingestellt wird.

7. Mehrere Digital/Analog-Converter nach Anspruch 6, wobei die geschalteten Stromquellen mehrere nicht-geschaltete Stromquellen enthalten, die gemeinsam durch das Fehlersignal und die mehreren Schalter gesteuert werden, die mit den nicht-geschalteten Stromquellen verbunden sind, zur Bildung der geschalteten Stromquellen.

## Revendications

1. Un convertisseur numérique - analogique de type sommation de courant, comprenant :
une source d'un mot de données d'entrée (W), **caractérisé par** :
une pluralité de sources de courant commuté (120) qui sont commandées en commun dans un aménagement en miroir de courant (110, 111) et qui sont sélectionnées conformément audit mot de données pour produire, à partir des courants des sources de courant sélectionnées, un signal de sortie analogique (tension à 124) ;
une source d'un signal de référence (VREF) à un niveau de référence ; et
un comparateur (131) sensible audit signal de référence et à un signal qui indique ledit signal de sortie pour générer un signal d'erreur (ERROR) conformément à une différence entre les deux, ledit signal d'erreur étant couplé audit aménagement en miroir de courant pour ajuster automatiquement ledit signal de sortie analogique à la manière d'une boucle d'asservissement.

2. Un convertisseur numérique - analogique selon la revendication 1 **caractérisé en outre par** un premier commutateur (141) sensible à un signal de commande de commutation périodique (SAMP) et couplé à une première capacitance (VCP1) et audit comparateur pour échantillonner ledit signal d'erreur, pendant un intervalle d'échantillonnage d'erreur, et pour stocker ledit signal d'erreur échantillonné dans ladite première capacitance pour produire un signal de commande d'échelle de conversion (1145) qui est couplé audit aménagement en miroir de courant dudit convertisseur numérique - analogique pour commander une échelle de conversion.

3. Un convertisseur numérique - analogique selon la revendication 2, **caractérisé en outre par** une seconde capacitance (CP2) qui est couplée à ladite première capacitance (CP1), en dehors de l'intervalle d'échantillonnage d'erreur, pour intégrer ledit signal d'erreur échantillonné dans ladite seconde capacitance.

4. Un convertisseur numérique - analogique selon la revendication 2, **caractérisé en ce que**, pendant ledit intervalle d'échantillonnage d'erreur, ledit mot de données (W) a une valeur prédéterminée (11... 1) qui est associée audit niveau dudit signal de référence et, en dehors de l'intervalle d'échantillonnage d'erreur, ledit mot de données contient des informations vidéo de pixel.

5. Un convertisseur numérique - analogique selon la revendication 4, **caractérisé en ce que**, pendant ledit intervalle d'échantillonnage d'erreur (ERROR), une valeur dudit mot de données d'entrée (11... 1) qui est appliquée audit convertisseur numérique - analogique correspond à un signal de sortie à déviation maximale.

6. Une pluralité de convertisseurs analogique - analogique selon la revendication 1, où ledit réseau commuté comprend une pluralité de sources de courant commuté d'un convertisseur numérique - analogique de type sommation de courant, et où chacune de ladite pluralité de sources de courant commuté est ajustée par ledit signal d'erreur dans un aménagement en miroir de courant.

7. Une pluralité de convertisseurs analogique - analogique selon la revendication 6, où lesdites sources de courant commuté comprennent une pluralité de sources de courant non commuté commandées en commun par ledit signal d'erreur et une pluralité de commutateurs couplés auxdites sources de courant non commuté pour former lesdites sources de courant commuté.
